(19) Europäisches Patentamt
European Patent Office
Office européen des brevets

(11) **EP 0 399 390 B1**

(12) **EUROPÄISCHE PATENTSCHRIFT**

(45) Veröffentlichungstag und Bekanntmachung des Hinweises auf die Patenterteilung:
**23.10.1996 Patentblatt 1996/43**

(51) Int Cl.6: **H01J 37/30**, H01J 37/21,
H01J 37/305

(21) Anmeldenummer: **90109419.3**

(22) Anmeldetag: **18.05.1990**

(54) **Verfahren und Anordnung zur Steuerung der Bündelung eines Strahls monopolar geladener Partikel**

Device and process for controlling the focusing of a monopolar charged particle beam

Procédé et dispositif pour la commande de focalisation d'un faisceau de particules chargées monopolaires

(84) Benannte Vertragsstaaten:
**AT BE CH DE ES FR GB IT LI LU NL SE**

(30) Priorität: **23.05.1989 DE 3916787**

(43) Veröffentlichungstag der Anmeldung:
**28.11.1990 Patentblatt 1990/48**

(73) Patentinhaber: **BALZERS AKTIENGESELLSCHAFT**
**9496 Balzers (LI)**

(72) Erfinder:
• **Wegmann, Urs**
**CH-9479 Oberschan (CH)**
• **Koller, Albert**
**CH-7320 Sargans (CH)**

(74) Vertreter: **Troesch, Jacques J., Dr. sc. nat. et al**
**Troesch Scheidegger Werner AG**
**Siewerdtstrasse 95**
**8050 Zürich (CH)**

(56) Entgegenhaltungen:
**DE-C- 2 719 725          US-A- 4 064 352**

• **PATENT ABSTRACTS OF JAPAN, Band 14, Nr. 125 (E-900)[4068], 8. März 1990; & JP-A-1 319 242 (HITACHI) 25-12-1989**

**Beschreibung**

Die vorliegende Erfindung betrifft ein Verfahren und eine Anordnung zur Steuerung der Bündelung eines Strahls monopolar geladener Partikel, insbesondere von Elektronen, gemäss dem Oberbegriff von Anspruch 1, bzw. von Anspruch 15.

Es ist bekannt, die Bündelung eines Strahls monopolar geladener Partikel mittels Einwirkung eines magnetischen Flussdichtefeldes zu steuern. Derartige Strahlen, insbesondere Elektronenstrahlen, werden beispielsweise zum Verdampfen von Substanzen in Vakuumbeschichtungsanlagen eingesetzt. Dabei ist es wichtig, die Auftreff-Fläche des Strahls auf dem zu verdampfenden Material nebst ihrer Form oder Ausdehnung auch in ihrer Lage gesteuert verändern zu können, d.h. den Strahl nebst gesteuert bündeln, auch gesteuert ablenken zu können. Mit der Steuerung der Bündelung, d.h. der Form oder Ausdehnung der Auftreff-Fläche auf dem zu verdampfenden Material wird z.B. ein gleichmässiger Abtrag des zu verdampfenden Materials angestrebt und/oder der Vielfalt thermischer Charakteristika der zu verdampfenden Materialien Rechnung getragen.

Bei der Steuerung der Bündelung mittels magnetischer Flussdichtefelder wird ausgenützt, dass bewegte, geladene Partikel, wie Elektronen oder Ionen, darin eine Kraft erfahren, die einerseits proportional ist zur Ladung des betrachteten Partikels, anderseits proportional zum Kreuzprodukt aus Partikelgeschwindigkeit $\bar{v}$ und magnetischer Flussdichte $\bar{B}$.

Aus der US-A-4 064 352 ist ein solches Verfahren bekannt geworden.

Gemäss dieser Schrift sind beidseits des Elektronenstrahls ausgedehnte Polschuhe vorgesehen, zwischen welchen ein weitgehend homogenes Magnetfeld aufgrund eines Magneten erzeugt wird.

An den verengten Luftspalten zwischen einragenden Magnetkernen ist das Feld inhomogen.

Im weiteren zeigt die DE-PS 27 19 725 eine elektromagnetische Elektronenstrahlfokussierungstechnik für einen ausgeprägten Flachstrahl bei der, grundsätzlich der Quadrupoltechnik folgend, in einer Ebene senkrecht zur Strahlausbreitungsrichtung, ein umlaufender rechteckiger Rahmenkern vorgesehen ist, auf dessen Schenkeln Wicklungsanordnungen vorgesehen sind. Die die Bündelungssteuernden Felder, antiparallel, sind so auf einer Strecke ausgelegt die der Ausdehnung des Flachstrahls entspricht. Eine Verschiebung des Strahls ist nicht vorgesehen, wie bei einer verstellbaren Strahlumlenkung.

Die vorliegende Erfindung setzt sich zum Ziel ein Verfahren bzw. eine Anordnung genannter Art zu schaffen mit denen die Bündelung in einer Richtung, in Grenzen, unabhängig von der Lage des Strahls in Richtung quer dazu einstellbar ist bzw. eine eingestellte Bündelung bei Verschiebung des Strahls in der erwähnten Quer-richtung unbeeinflusst bleibt.

Im Zusammenhang mit der vorliegenden Anmeldung vornehmlich von Interesse sind Zusatzwicklungen.

Daraus ist insbesondere ersichtlich, dass die in Richtung der sich gegenüberliegenden Magnetkerne gerichteten Komponenten der Feldvektoren auf den Elektronenstrahl in Richtung quer dazu umlenkend wirken und dass, vorerst ohne Berücksichtigung der Elektromagnete, die jeweiligen Quer-Komponenten der Magnetfeldvektoren, der Felder zwischen je den sich gegenüberliegenden Kernenpaaren einander entgegenwirken.

Wird nun mit Hilfe der Elektromagnetanordnung das Feld im Luftspalt zwischen einem Kernenpaar verstärkt und dasjenige im Luftspalt zwischen dem anderen in gleichem Masse geschwächt, so bleibt wohl die umlenkende Feldkomponente in Richtung von Kern zu Kern genau auf einer Koordinate, beispielsweise auf einer Symmetrieebene zwischen den beiden Luftspalten der Kernpaare, konstant, und der Elektronenstrahl bleibt dann trotz Aenderung der Feldstärken von Umlenkfeldkomponenten in Richtung von Kern zu Kern, d. h. der Kernpaare unbeeinflusst, wenn, was nur idealisiert der Fall ist, die Quer-Ausdehnung des Elektronenstrahls vernachlässigbar ist. Andernfalls ergeben sich links und rechts auf die dortigen Elektronen unterschiedliche Umlenkkräfte und damit eine Verlagerung des Elektronendichteschwerpunktes über den Strahl, was einer Aenderung der Strahlumlenkung in Quer-Richtung sowie einer Aenderung seiner Bündelung in dieser Richtung entspricht.

Diese Auswirkung wird gemäss der erwähnten Schrift vernachlässigt. Es wird angenommen, dass bei der erwähnten Feldänderung die Aenderung der Komponenten in Kernpaar-Richtung den Strahl nicht beeinflussen. Ausgenützt wird die Aenderung der Feldvektorkomponenten in Quer-Richtung. Wird, wie beispielsweise erläutert, das Feld im einen Kernpaar-Luftspalt verstärkt, hingegen dasjenige im anderen Kernpaar-Luftspalt geschwächt, so überwiegen nun die Quer-Vektorkomponenten im ersten Luftspalt.

Es resultieren, beidseits des Elektronenstrahls Vektorkomponenten in Quer-Richtung, die, per definitionem, zueinander parallel sind und einander entgegengerichtet sind. Dadurch wird die Bündelung des Elektronenstrahls in Kernpaar-Richtung beeinflusst.

Mit der hier gezeigten Anordnung ist eine Verstellung der Bündelung des Strahls ohne dass dabei auch die Strahlumlenkung beeinflusst würde, nicht möglich. Ebenso ist es nicht möglich, ohne Nachstellen der Bündelungs-Steuerfelder die Lage des Strahls quer zur Bündelungswirkung zu ändern.

Die vorliegende Erfindung setzt sich mithin zum Ziel, ein Verfahren zur Steuerung der Bündelung zu schaffen, welches selber im wesentlichen eine Ablenkung des Strahls nicht beeinflusst, womit ermöglicht wird, an einer elektrooptischen Einrichtung die Bündelung im wesentlichen unabhängig von der Ablenkung anzusteuern. Die Steuerung soll direkt und somit mit hohem Wirkungsgrad auf die Bündelung wirken, was weiter ermöglicht, die Bündelung in einem grossen Stellbereich zu ändern und zudem schnell.

Dies wird nach dem Wortlaut des kennzeichnenden Teils von Anspruch 1 erreicht.

Das erfindungsgemässe Vorgehen sowie die bevorzugten Vorgehensvarianten verfahrensmässig und anordnungsmässig werden nachfolgend direkt anhand der Figuren erläutert, da anhand von Figuren die räumliche Vorstellung wesentlich leichter ist.
Es zeigen die Figuren beispielsweise:

Fig. 1 eine räumliche Anordnung von Strahl- und Flussdichtefeldern gemäss Stand der Technik sowie ihre Wirkungsweise,

Fig. 2 eine Darstellung analog zu Fig. 1 des erfindungsgemässen Vorgehens,

Fig. 3 eine Darstellung erfindungsgemäss bevorzugterweise angesteuerter Flussdichtefeldverhältnisse, bei Betrachtung der Felder gemäss Fig. 2 in x-Richtung,

Fig. 4 eine schematische Aufsicht auf die Verhältnisse gemäss Fig. 2, bei Anlegen von zwei zueinander rechtwinklig stehenden Flussdichtefeldern in einer ersten erfindungsgemässen Polaritätsrelation,

Fig. 5 eine Darstellung analog zu Fig. 4 mit Feldern in einer zweiten erfindungsgemässen Polaritätsrelation,

Fig. 6a eine schematische Aufsicht auf einen stark umgelenkten Strahl gemäss einer Aufsicht auf die Verhältnisse gemäss Fig. 2 mit einer beispielsweisen Bündelungsänderung des Strahls mittels Feldern gemäss Fig. 4,

Fig. 6b eine Ansicht auf den gemäss Fig. 6a weitwinklig umgelenkten Strahl gemäss einer sich in y-Richtung gemäss Fig. 2 mit den bei Aenderung einer Bündelung sich ändernden Verhältnissen,

Fig. 7 schematisch das Anordnen von zwei orthogonalen Flussdichtefeldern in Ausbreitungsrichtung des Strahls versetzt,

Fig. 8 schematisch eine erfindungsgemässe Anordnung zur Realisierung der in den Fig. 2 bis 6 dargestellten Verhältnisse,

Fig. 9 eine Anordnung analog zu Fig. 8, bei Vorsehen eines weiträumig wirkenden Umlenkfeldes für den Strahl zur Erzeugung von Umlenkverhältnissen analog den in Fig. 6a und 6b dargestellten,

Fig. 10 schematisch in Aufsicht eine Anordnung gemäss den Fig. 8 oder 9 zur Erzeugung von Feldverhältnissen in Analogie zu den in Fig. 4 dargestellten,

Fig. 11 schematisch eine Anordnung zur Erzeugung orthogonaler Bündelungssteuerfelder, gemäss den Fig. 4, 5 und bei axialer Feldversetzung gemäss Fig. 7,

Fig. 12 in perspektivischer Ansicht den Aufbau einer bevorzugten Ausführungsform einer erfindungsgemässen Anordnung, prinzipiell aufgebaut gemäss den Fig. 8 und 9.

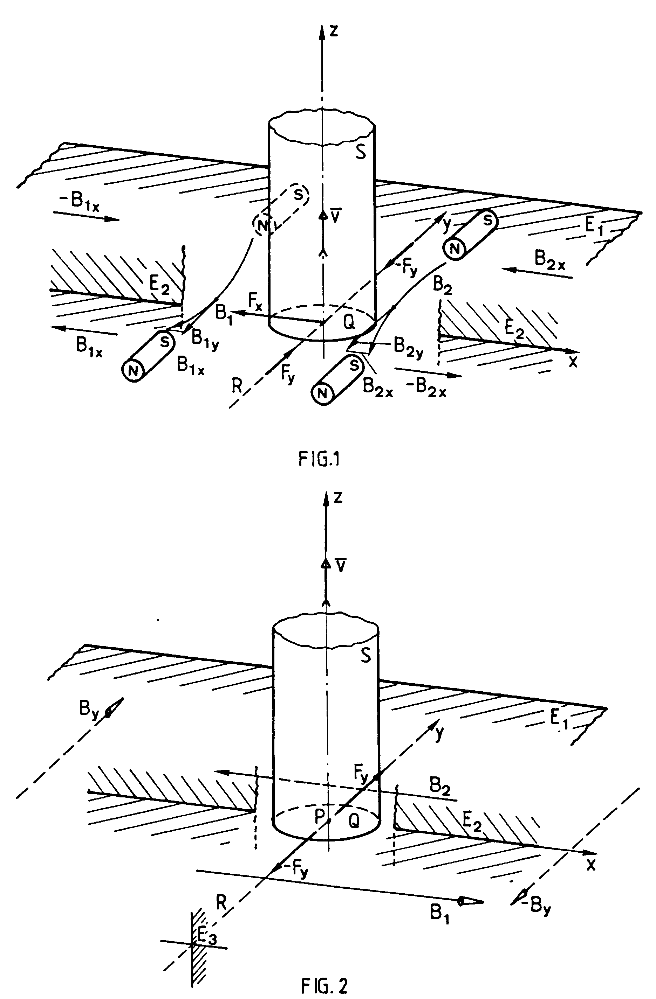

In Fig. 2 ist die räumliche Anordnung des Strahls monopolar geladener Partikel S und der hierzu querstehenden Ebene $E_1$ dargestellt, mit der Strahldurchtrittsfläche Q. Im weiteren ist die Richtung R eingetragen, entlang welcher die Ausdehnung der Strahldurchtrittsfläche Q gesteuert verändert werden soll, sowie die Ebene $E_2$, welche senkrecht zur Ebene $E_1$ und zur Richtung R, der Y-Achse im xyz-Koordinatensystem entsprechend, liegt. Erfindungsgemäss wird nun beidseits der Ebene E ein Flussdichtefeld $\bar{B}$ angelegt, mit im wesentlichen parallelem Feldverlauf, wobei auf der einen Seite der Ebene $E_2$ das Flussdichtefeld die eine, auf der anderen Seite die andere Polarität aufweist. Durch die beiden erfindungsgemäss angelegten Flussdichtefelder $\bar{B}_1$ und $\bar{B}_2$ wird, auf die Flächenladung in der Strahldurchtrittsfläche Q, auf einer Seite der Ebene $E_2$ eine Kraft $F_y$ und auf der anderen Seite dieser Ebene eine Kraft $F_y$ ausgeübt, so dass, je nach Polaritäten der beiden Flussdichtefelder $\bar{B}_1$ und $\bar{B}_2$, die Kräfte stauchend oder dehnend auf die genannte Fläche Q wirken.

Sofern die Felder $\bar{B}_1$ und $\bar{B}_2$ entlang der x-Ausdehnung der Fläche Q mindestens im wesentlichen keine Krümmung aufweisen, erfahren die Ladungsträger in der Fläche Q mindestens im wesentlichen keine Kräfte in x-Richtung, und mit Ansteuerung der Feldstärke, d.h. der Beträge der Vektoren $\bar{B}_1$ bzw. $\bar{B}_2$ und deren Polarität, wird die Ausdehnung der Flächenladung Q in y-Richtung angesteuert, was, bei konstant gehaltener Ausdehnung in x-Richtung, wenn, wie erwähnt, mindestens in diesem Bereich die Feldkrümmung vernachlässigbar ist, dazu führt, dass die Ladungsdichte (Flächenladung) durch Vergrösserung der Fläche Q in y-Richtung verringert wird.

Werden aber, wie gestrichelt eingetragen, die erfindungsgemäss angelegten Flussdichtefelder B und $\bar{B}_2$ im Bereich der Ausdehnung der Durchtrittsfläche Q gekrümmt erzeugt, so ergeben sich dadurch zur Ebene $E_2$ senkrecht stehende Komponenten $B_y$ bzw. $-B_y$, wie eingetragen, woraus ersichtlich wird, dass auch in diesem Fall übersichtliche Verhältnisse entstehen, indem dann, wenn die Durchtrittsfläche Q in Richtung y gedehnt wird, sie gleichzeitig in Richtung x gestaucht wird und umgekehrt.

Um jedoch Unabhängigkeit von Flächenausdehnungsveränderungen in der einen Richtung, y, von derartigen Veränderungen in der anderen, x, zu erreichen, wird die Bedingung der Parallelität der beiden Flussdichtefelder $\bar{B}_1$ und $\bar{B}_2$ mindestens über einen Bereich, welcher der Ausdehnung der Durchtrittsfläche Q entspricht, erfüllt. Dadurch entstehen bei gesteuerter Veränderung der Flussdichtefelder $\bar{B}_1$ und $\bar{B}_2$ keine Querkomponenten dieser Felder in y-Richtung, womit die Ladungen in der Fläche Q auch nur in y-Richtung kraftbeaufschlagt werden.

Bei der Beurteilung, ob bei der Bündelungssteuerung der Strahl auch eine Ablenkung erfährt oder nicht, ist vorerst zu definieren, wann eine Aenderung der Bündelung als Strahlablenkung zu bezeichnen ist. Es erfährt eine Ladung innerhalb der Strahldurchtrittsfläche Q dort keine Kraft - womit die Bahn einer solchen Ladung bzw. des entsprechenden Partikels unbeeinflusst bleibt - wo sich die erfindungsgemäss angelegten Flussdichtefelder $\bar{B}_1$, $\bar{B}_2$ aufheben. Anderseits kann bereits als Ablenkung bezeichnet werden, wenn sich die Lage des Ladungsschwerpunktes aller in der Ebene $E_1$ momentan auftretenden Ladungen verschiebt. Die Lage des Ladungsschwerpunktes, der in der Fläche Q, momentan betrachtet, liegenden Ladungen, verändert sich dann nicht, wenn die beiden Flussdichtefelder $\bar{B}_1$ und $\bar{B}_2$ beidseits der zweiten Ebene $E_2$ symmetrisch angelegt werden und diese Symmetrie bei gesteuerter Veränderung der Felder beibehalten wird.

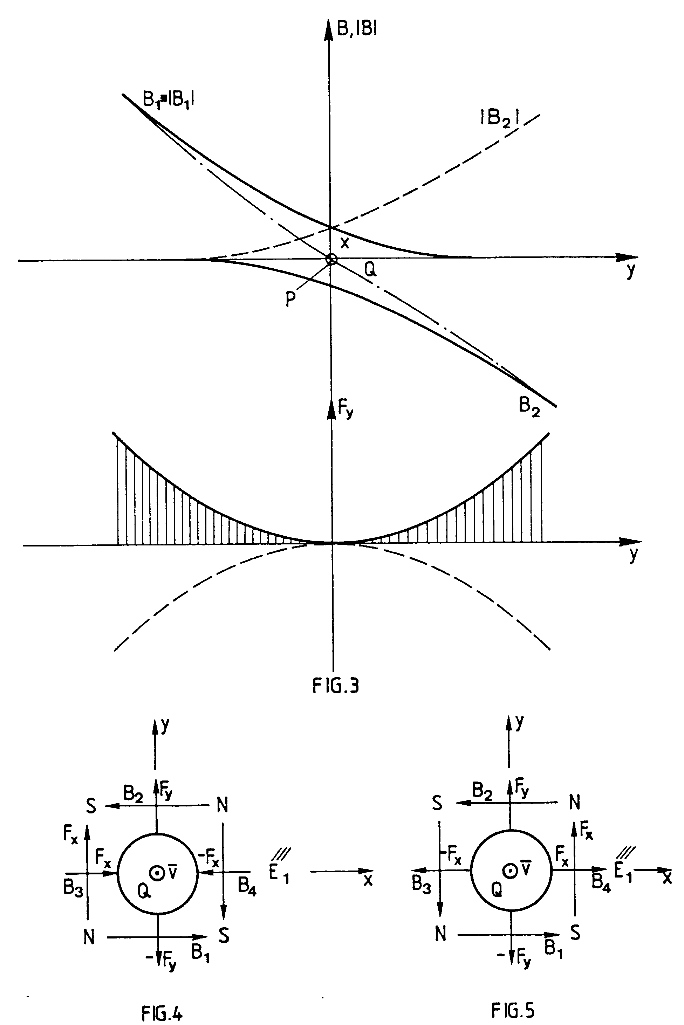

Dies soll anhand von Fig. 3 erläutert werden. In Fig. 3 ist über der Y-Achse, worauf die Ausdehnung der Durchtrittsfläche Q aufgetragen ist, der Effektivwert $B_1$, $B_2$ der beiden Flussdichtefelder $\bar{B}_1$ und $\bar{B}_2$ aufgetragen. Der Verlauf dieser Werte ist rein qualitativ dargestellt und entspricht etwa dem abnehmenden Verlauf mit zunehmender Distanz von einem erzeugenden magnetischen Dipol. Wird die Ebene $E_2$ in den Ladungsschwerpunkt P der Flächenladung über der Fläche Q gelegt und soll dieser Ladungsschwerpunkt P bei Aenderung der Flächenausdehnung in Richtung y durch die erfindungsgemäss angelegten Flussdichtefelder nicht verändert werden, so werden diese beiden Felder $\bar{B}_1$ und $\bar{B}_2$ so angelegt, dass sie sich in der Ebene E aufheben. Der resultierende Verlauf ist qualitativ strichpunktiert dargestellt. Sind nun im weiteren die beiden Flussdichtefelder $\bar{B}_1$ und $\bar{B}_2$ so ausgelegt, dass ihre Beträge $|B_1|$, $|B_2|$ zur Ebene $E_2$ symmetrisch liegen, wie gestrichelt eingetragen, und diese Bedingung auch bei Veränderung der Felder beibehalten, so wird erreicht, dass sich die Felder einerseits und örtlich betrachtet am Ort P weiterhin aufheben, und dass auf die Flächenladung beidseits der Ebene $E_2$ Kräfte gleicher Beträge wirken, womit die Ladungen in der Fläche Q bezüglich der Ebene $E_2$ symmetrisch geänderte Bahnen durchlaufen. Dadurch bleibt der Ladungsschwerpunkt am Ort P und es erfolgt keine Ablenkung des Strahles. Die wannenartige Verteilung der entstehenden Kräfte $F_y$ ist in Fig. 3 qualitativ dargestellt, gestrichelt bei Polaritätswechsel.

Es ist, beispielsweise aus der erwähnten US-A- 4 064 352 bekannt, Elektronenstrahlen, als Strahlen geladener Partikel, im Einsatz in Vakuumanlagen in einer gebogenen Bahn vom Strahlerzeuger auf das zu verdampfende Material zu lenken, und zwar teilweise um wesentlich mehr als um 180° bis in den Bereich von 270° oder gar mehr. Um dies realisieren zu können, muss, grundsätzlich wiederum mit einem magnetischen Flussdichtefeld, entlang ausgedehnter Abschnitte der Strahlbahn eingewirkt werden. Dies bedingt des öftern, dass schon kurz nach dem Strahlerzeuger in diesem Sinne umlenkende Flussdichtefelder angelegt werden müssen, um schliesslich die erwünscht grosse Umlenkung zu erzielen. Somit ist es in vielen Fällen nicht möglich, auch aus Gründen einer anzustrebenden kompakten Bauweise einer Elektronenoptik, für die erwähnte Umlenkung und für eine Bündelungssteuerung der hier zur Diskussion stehenden Art, die Umlenkung erst in einem Bahnabschnitt vorzunehmen, derart weit von der Bündelungssteuerung entfernt, dass durch die Umlenkung und deren Veränderung zur Aenderung der Lage der Auftrittsfläche des Strahles auf dem zu verdampfenden Material nicht auch eine Aenderung der Bündelung des Strahls eintritt.

Wie aus Fig. 3 ersichtlich, ergibt sich nämlich dann, wenn durch solche Umlenkmassnahmen die Lage der Fläche Q verändert wird, dass damit die entsprechenden Flächenladungen in sich ändernde Verhältnisse des erfindungsgemäss angelegten Feldes eintreten, womit dann mit der Umlenkung auch Aenderungen der Bündelung auftreten. In Anbetracht dieser Erfordernisse ist es im weiteren öfters wesentlich, den Strahl mindestens in einer Richtung ablenken zu können, ohne dass dabei die Bündelungsverhältnisse ändern. Dies ist bei Betrachten von Fig. 2 ohne weiteres möglich, bei Vorgehen gemäss der vorliegenden Erfindung:

Bei den in Fig. 2 eingetragenen Verhältnissen der beiden erfindungsgemäss angelegten Flussdichtefelder $B_1$ und $B_2$ ist es möglich, den Strahl und damit seine Durchtrittsfläche Q in x-Richtung zu verschieben, ohne dass dabei die erfindungsgemäss angesteuerten Bündelungsänderungen in y-Richtung tangiert würden. Damit wird ersichtlich, dass eine weitere bevorzugte Ausführungsvariante des erfindungsgemässen Verfahrens darin besteht, die Felder beidseits der zweiten Ebene über einen Bereich, der wesentlich länger ist als die Ausdehnung der Durchtrittsfläche Q, konstant anzulegen, und zwar in dem Sinne, dass die Feldverhältnisse im genannten Bereich und fortschreitend in x- oder -x-Richtung unverändert bleiben. Wird nun nämlich beispielsweise für die erwähnte, grosswinklige Strahlumlenkung diese Umlenkung in der Ebene $E_2$ vorgenommen, so kann diese bereits vor dem erfindungsgemässen Ansteuern der Bündelung angegangen werden und zur Aenderung der Auftreff-Flächenlage auch verändert werden, ohne dass dadurch die erfindungsgemäss eingestellte Bündelung beeinflusst würde.

Betrachtet man den Verlauf der Beträge $|B_1|$, $|B_2|$ der angelegten Flussdichtefelder gemäss Fig. 3, so wird ersichtlich, dass dadurch eine dreidimensionale Fläche aufgespannt wird, mit einem in x-Richtung verlaufenden Tal, das beidseits ansteigt.

In manchen Fällen kann es erwünscht sein, die Bündelung des Strahles mehrerer, wie in zwei zueinander senkrechten Richtungen, abhängig voneinander cder unabhängig voneinander, ansteuern zu können, d. h. grundsätzlich und gemäss Fig. 2 sowohl in y-wie auch in x-Richtung. Hierzu wird vorgeschlagen, dass man bezüglich einer dritten Ebene, in Fig. 2, $E_3$, welche senkrecht zur ersten, $E_1$, und zur zweiten, $E_2$, steht, und welche die Richtung R enthält, beidseits ein zweites Flussdichtefeld anlegt, mit beidseits parallelen Vektorkomponenten umgekehrter Polarität und vorzugsweise bezüglich der dritten Ebene symmetrischen Beträgen. Ein solches zweites Flussdichtefeld entspricht den bereits in Fig. 2 gestrichelt mit $B_y$ und $-B_y$ eingetragenen Feldern, welche entstehen, wenn, wie oben erläutert wurde, das erste Flussdichtefeld $\bar{B}_1$ bzw. $\bar{B}_2$, wie ebenfalls in Fig. 2 gestrichelt eingetragen, gekrümmt ist.

In Fig. 4 ist, in Aufsicht auf eine Darstellung analog zu Fig. 2, das erste magnetische Flussdichtefeld mit den Anteilen $\bar{B}_1$ und $\bar{B}_2$ gemäss Fig. 2 eingetragen, und das zweite, senkrecht dazu stehende Flussdichtefeld mit den Anteilen $\bar{B}_3$ und $\bar{B}_4$. In der Konstellation gemäss Fig. 4 wechseln sich, wenn man um die Durchtrittsfläche Q umläuft, die Polaritäten der Flussdichtefelder $\bar{B}$ ab. Damit entstehen die ebenfalls in Fig. 4 eingetragenen Kräfteverhältnisse, d.h., wenn die Polaritätsverhältnisse beibehalten werden, wird in der einen der Richtungen, x bzw. y, die Fläche Q gestaucht bzw. gedehnt und in der anderen, y bzw. x, gedehnt bzw. gestaucht. Diese Felder-Polaritätskonstellation kann ohne weiteres durch Vorsehen zweier magnetischer Dipole realisiert werden, wie aus der Polverteilung um die Fläche Q ersichtlich ist.

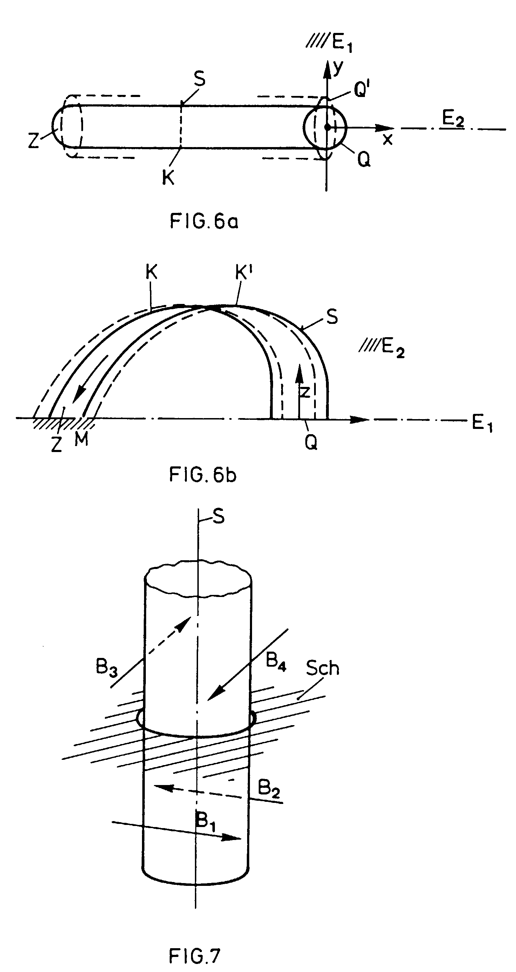

In Fig. 5 ist eine weitere, Auslegung der Flussdichte-felder dargestellt, in einer analogen Darstellung zu Fig. 4. Hier wechseln sich, beim Umlaufen um die Durchtrittsfläche Q, die Polaritäten der Flussdichte-Feldanteile $\bar{B}_1$ bis $\bar{B}_4$ nicht ab. Bei dieser Konstellation der Polaritäten wirken, wie eingetragen, alle durch die Feldanteile bewirkten Kräfte entweder nach aussen oder nach innen, womit ein zentralsymmetrisches Aufweiten bzw. Konzentrieren der Durchtrittsfläche Q ermöglicht wird. Diese Polaritätskonstellation kann, wie aus den eingetragenen Magnetpolen ohne weiteres ersichtlich, nicht durch zwei magnetische Dipole realisiert werden, und es sind hierzu weitere Vorkehrungen zu treffen, wie anhand von Fig. 7 erläutert werden wird.

Soll durch das angelegte zweite Flussdichtefeld mit den Anteilen $B_3$ und $B_4$ in beiden Polaritätsverteilungen gemäss den Fig. 4 und 5 nur die Bündelung des Strahls entsprechend einer Veränderung seiner Durchtrittsfläche Q in Richtung x bzw. -x beeinflusst werden, so wird dieses zweite Flussdichte-feld wiederum mindestens auf einer Länge entsprechend der Ausdehnung der Fläche Q in y-Richtung parallel ausgelegt. Bezüglich der bevorzugten symmetrischen Auslegung der Beträge des zweiten angelegten Flussdichtefeldes gelten die anhand von Fig. 3 für das erste angelegte Flussdichtefeld gemachten Ueberlegungen: Dies ist ein Erfordernis, sofern angestrebt wird, den Ladungsschwerpunkt der in der Fläche Q momentan liegenden Flächenladungen nicht zu verschieben.

Wenn auch das zweite angelegte Flussdichtefeld so angelegt wird, dass die Felder beidseits der dritten Ebene über einen Bereich, der wesentlich länger ist als die Ausdehnung der Durchtrittsfläche Q, konstant sind, so wird gemäss den Fig. 4 und 5 die in x-Richtung bewirkte Aenderung der Bündelung durch das zweite Flussdichtefeld mit den Teilen $\bar{B}_3$ und $\bar{B}_4$ nicht beeinflusst von einer Auslenkung des Strahles in y-Richtung, welche eine örtliche Verschiebung der Durchtrittsfläche Q bewirkt. Die Kombination, dass nämlich die Bündelung in y-Richtung, bewirkt durch das erste Flussdichtefeld $\bar{B}_1$ und $\bar{B}_2$ nicht beeinflusst ist durch eine Verschiebung der Fläche Q bzw. des Strahls in x-Richtung, und dass die Bündelung in x-Richtung, bewirkt durch das zweite Flussdichtefeld mit den Teilen $\bar{B}_3$ und $\bar{B}_4$, nicht beeinflusst ist durch eine Verschiebung der Durchtrittsfläche Q und mithin des Strahls in y-Richtung, wird in manchen Fällen angestrebt, um insbesondere den Abgleich der Bündelungssteuerfelder an einem Arbeitspunkt des Strahls leichter vorzunehmen, um welchen er in x- und y-Richtung nachmals im Betrieb abgelenkt wird.

Die Polaritätsverteilung gemäss Fig. 4 kann in gewissen Anwendungsfällen wesentliche Vorteile aufweisen. Wie erwähnt wurde, ist es in manchen Fällen der Anwendung von Elektronenstrahlen üblich, diese in einer Ebene stark umzulenken. Beim erfindungsgemässen Auslegen des ersten Flussdichtefeldes mit den Anteilen $\bar{B}_1$ und $\bar{B}_2$ gemäss Fig. 2 ist es angezeigt, wie in Fig. 6a in Aufsicht dargestellt, diese Umlenkung des Strahls S in der zweiten Ebene $E_2$ vorzunehmen. In Seitenansicht ist in Fig. 6b der Verlauf des Strahls S in der Ebene $E_2$ dargestellt. Bei einer solchen Umlenkung entsteht üblicherweise, wie auch aus der US-A- 4 064 352 bekannt, in Seitenansicht gemäss Fig. 6b, ein Bereich K, an welchem der Strahl eingeschnürt ist. In Aufsicht, d.h. in der Umlenkungsebene $E_2$, entsteht vielfach eine derartige Einschnürung nicht.

Diese Verhältnisse werden nun beim Vorgehen gemäss Fig. 4 und entsprechend Anspruch 8 optimal ausgenützt. Wenn gemäss Fig. 4 mit dem ersten Flussdichtefeld $\bar{B}_1$, $\bar{B}_2$ eine Ausdehnung der Querschnittsfläche Q und somit des Strahls in y-Richtung erfolgt, so ergeben sich die in Fig. 6a gestrichelt dargestellten Verhältnisse. Gleichzeitig kann mit dem zweiten angelegten Flussdichtefeld mit den Anteilen $\bar{B}_3$ und $\bar{B}_4$, allenfalls direkt gekoppelt mit dem ersten Flussdichtefeld, eine Stauchung der Durchtrittsfläche Q vorgenommen werden. Es resultieren dabei die in Fig. 6a gestrichelt eingetragenen Querschnittsflächen Q'.

Auf Fig. 6b blickend, ergibt sich aber bei der Reduzierung der Durchtrittsflächenausdehnung Q in x-Richtung eine Verschiebung des Einschnürungsbereiches K z.B. an den Bereich K', d.h. näher zur Strahlquelle hin. Dies entspricht der Verschiebung eines Fokuspunktes näher zur Lichtquelle hin. Damit entsteht auf dem Ziel, beispielsweise dem zu verdampfenden Material M in Richtung x betrachtet, bzw. in der Ebene $E_2$, das Inverse, d.h., wenn in dieser Richtung die Durchtrittsfläche Q gestaucht wird, wird die Auftrittfläche auf dem Material M wegen der Verschiebung des Einschnürungsbereiches K' vergrössert. Damit ist der Vorteil der in Fig. 4 dargestellten Polaritätswahl, insbesondere im Falle grosser Umlenkung des betroffenen Elektronenstrahls S um mehr als 90°, insbesondere mehr als 180°, manifest: Gerade durch diese Polaritätswahl wird die Auftreff-Fläche Z in Fig. 6 radial nach allen Richtungen ausgeweitet oder komprimiert. Die resultierende, qualitative Strahlverteilung ist in Fig. 6b ebenfalls gestrichelt dargestellt. Die Lage des Einschnürungsbereiches im Sinne eines Arbeitspunktes, um den diese Lage durch Aenderung der Bündelung ändert, wird grundsätzlich durch den Strahlerzeuger sowie die elektrooptischen Massnahmen zur Strahlformung festgelegt.

Während, wie noch zu erläutern sein wird, bei Wahl einer Polaritätskonfiguration gemäss Fig. 5 dies vorzugsweise dadurch realisiert wird, dass das erste Flussdichtefeld $\bar{B}_1$, $\bar{B}_2$ und das zweite Flussdichtefeld $\bar{B}_3$, $\bar{B}_4$ entlang der Strahlachse versetzt angelegt werden, werden bei der Ausführungsvariante gemäss Fig. 4 die beiden Flussdichtefelder im wesentlichen in derselben, der ersten Ebene $E_1$ angelegt.

Soll in der Polaritätskonfiguration gemäss Fig. 4 oder Fig. 5 erreicht werden, dass das erste Flussdichtefeld $\bar{B}_1$, $\bar{B}_2$ unabhängig vom zweiten $\bar{B}_3$, $\bar{B}_4$ und umgekehrt angesteuert werden kann, so wird gemäss Fig. 7 das erste Flussdichtefeld $\bar{B}_1$, $\bar{B}_2$ entlang der Ausbreitung des Strahls S versetzt vom zweiten Flussdichtefeld $\bar{B}_3$, $\bar{B}_4$ angelegt. Bevorzugterweise wird zwischen den beiden Flussdichtefeldern eine magnetische Abschirmung SCH vorgesehen, damit sich die beiden Felder nicht gegenseitig beeinflussen. Dieses Vorgehen ist bei der Polaritätswahl gemäss Fig. 5 ohnehin angezeigt. Allerdings kann diese Konfiguration auch durch zeitgestaffelte Erzeugung der Felder $\bar{B}_1$, $\bar{B}_2$ einerseits und $\bar{B}_3$, $\bar{B}_4$ anderseits in der Ebene $E_1$ erfolgen.

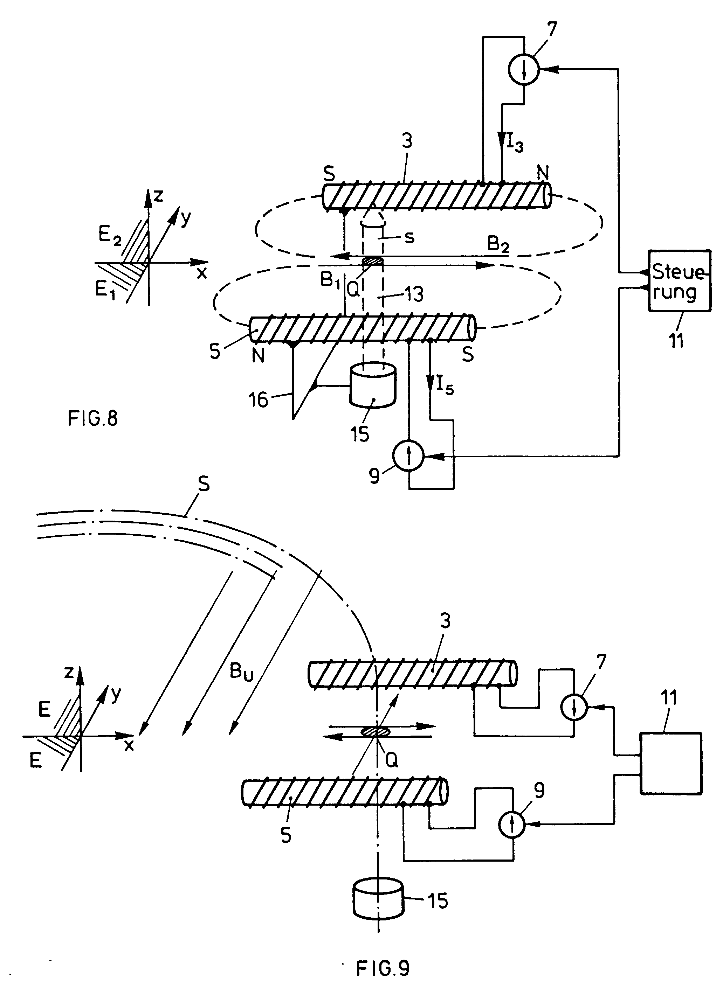

In Fig. 8 ist schematisch und beispielsweise eine erfindungsgemässe Anordnung zur Steuerung der Bündelung dargestellt. Sie umfasst eine Magnetanordnung, die grundsätzlich so ausgebildet ist, dass die Vektorkomponenten des durch die Magnetanordnung erzeugten Flussdichtefeldes, wie anhand von Fig. 2 und 3 erläutert wurde, erzeugt werden. Bevorzugterweise ist die Magnetanordnung durch ein Paar Dipole 3 und 5 gebildet, welche bevorzugterweise durch Elektromagnetanordnungen gebildet werden, je gespiesen über Stromquellen 7 bzw. 9, welche durch eine Steueranordnung 11 angesteuert werden. Die Dipole 3 und 5 können aber auch, wie für Arbeitspunkt-Einstellungen der Bündelung, durch Permanentmagnete gebildet sein oder Permanentmagnete umfassen. An der Anordnung ist ein Bereich 13 definiert, durch welchen der Strahl monopolar geladener Partikel, insbesondere von Elektronen, S, durchgeschickt wird. Hierzu ist, bezüglich der Dipolanordnung aus den Dipolen 3 und 5, die Lage eines in Fig. 8 schematisch dargestellten Strahlerzeugers 15 festgelegt bzw. festlegbar, wie mit Hilfe einer Fixierungsanordnung für den Strahlerzeuger 15 an bezüglich den Dipolen 3 und 5 definierter Lage. Eine entsprechende Fixierung der Dipole 3, 5 und des Strahlerzeugers 15 ist bei 16 schematisch dargestellt. Wie aus Fig. 8 ersichtlich, werden durch die beiden Dipole 3 und 5 prinzipiell die in Fig. 2 erläuterten Komponenten $\bar{B}_1$ und $\bar{B}_2$ des Flussdichtefeldes erzeugt, ausgelegt bezüglich des Bereiches 13 für den Strahl S, wie anhand von Fig. 2 bezüglich des Strahles S erklärt wurde. Es wird dabei, in einer bevorzugten Ausführungsvariante, angestrebt, beidseits der in Fig. 8 ebenfalls eingetragenen Ebene $E_2$, den Verlauf des Flussdichtefeldes $\bar{B}_1$, $\bar{B}_2$ in einem Bereich, der mindestens dem Durchmesser der Strahldurchtrittsfläche Q entspricht, die durch den durch den Bereich 13 durchlaufenden Strahl S gebildet wird, im wesentlichen parallel auszubilden. Wie aus Fig. 8 ohne weiteres ersichtlich, wird dies auf einfache Art und Weise dadurch erreicht, dass die Länge der Dipole 3 bzw. 5, in x-Richtung betrachtet, wesentlich grösser ausgebildet wird als die in x-Richtung betrachtete Ausdehnung der Querschnittsfläche Q des durch den vorgesehenen Bereich 13 durchlaufenden Strahles S.

Mit Hilfe der Steuerung 11 werden die Flussdichtefeldanteile $\bar{B}_1$ und $\bar{B}_2$ beidseits des Durchtrittsbereiches 13 für den Strahl S, d.h. beidseits der Ebene $E_2$ so angesteuert, dass die Beträge der Flussdichtefelder beidseits dieser Ebene $E_2$ ihrbezüglich symmetrisch sind. Dadurch wird gemäss den Erläuterungen zu Fig. 3 erreicht, dass bei der mit den Flussdichtefeldern $\bar{B}_1$ und $\bar{B}_2$ angesteuerten Veränderung der Strahldurchtrittsfläche Q in y-Richtung der Ladungsschwerpunkt der in der Fläche Q momentan liegenden Flächenladung unverändert bleibt. Die Ansteuerung der Flussdichtefelder $\bar{B}_1$ und $\bar{B}_2$, so, dass diese Bedingung erfüllt ist, erfolgt je nach geometrischer Ausrichtung der beiden magnetischen Dipole 3 und 5 bezüglich der Ebene $E_1$, worin die Durchtrittsfläche Q des Strahles S gezielt beeinflusst werden soll, durch entsprechende Wahl bzw. Ansteuerung der mittels der Stromquellen 7 und 9 erzeugten Ströme.

Um im weiteren zu erreichen, dass die in y-Richtung durch die Magnetanordnungen 3 und 5 bewirkte Steuerung der Strahldurchtrittsfläche Q des durch den Bereich 13 durchlaufenden Strahls über eine relativ grosse Strecke, in x-Richtung betrachtet, unabhängig von der Lage des Strahls S in x-Richtung wird, wird weiter die Magnetfeldanordnung, vorzugsweise bestehend aus den zwei Dipolen 3 und 5, so ausgelegt, dass der Verlauf des Flussdichtefeldes $\bar{B}_1$ und $\bar{B}_2$ beidseits der erwähnten zweiten Ebene $E_2$ konstant ist, über einen Bereich, der wesentlich länger ist als die Ausdehnung der Durchtrittsfläche Q des Strahles S. Dies wird wiederum erreicht durch entsprechend lange Ausdehnung der Magnetdipole 3 bzw. 5, in x-Richtung betrachtet.

Obwohl es durchaus möglich ist, den Flussdichcefeldverlauf gemäss Fig. 2 durch räumliche Ueberlagerung mehrerer Flussdichtefelder zu erzeugen, wird, wie in Fig. 8 dargestellt, bevorzugterweise dieses Feld mittels einer Magnetanordnung erzeugt, die zwei im wesentlichen parallel zur zweiten Ebene angeordnete magnetische Dipole, nämlich die Dipole 3 und 5 aufweist. Diese beiden Dipole brauchen vorerst nicht in der Ebene $E_1$ zu liegen, und brauchen ebensowenig bezüglich der Ebene $E_2$ symmetrisch angeordnet zu sein. In weiten Grenzen lässt sich nämlich die geometrische Relativlage der beiden Dipole 3 und 5 mit Bezug auf den Wirkungsbereich, nämlich den Schnittbereich zwischen den Ebenen $E_1$ und $E_2$, frei wählen und trotzdem den erfindungsgemässen Flussdichtefeldverlauf am Wirkungsbereich durch entsprechende elektrische Ansteuerung der Magnetanordnungen erwirken.

Allerdings müssen dabei allenfalls komplizierte räumliche Feldüberlagerungen berücksichtigt werden. Wenn nicht aus anderen, beispielsweise konstruktiven Randbedingungen erforderlich, wird man deshalb die beiden magnetischen Dipole, wie in Fig. 8 dargestellt, im wesentlichen in die erste Ebene $E_1$ legen. Dann werden die Feldverhältnisse einfach überblickbar. Auch dann brauchen allerdings die beiden Dipole 3 und 5 noch nicht zwingend bezüglich der zweiten Ebene $E_2$ symmetrisch zu liegen, und es ist offensichtlich, dass eine Asymmetrie durch entsprechend asymmetrische Ansteuerung oder asymmetrische Wicklungen der Stromquellen 7 bzw. 9 bzw. der Elektromagnete kompensiert werden kann. Wenn nicht wiederum andere Randbedingungen, wie konstruktiver Art mit Bezug auf den Strahlerzeuger 15, dazu zwingen, wird man im weiteren bevorzugterweise und, wie in Fig. 8 dargestellt, die in der ersten Ebene liegenden magnetischen Dipole bezüglich der zweiten Ebene symmetrisch anordnen.

In Fig. 9 sind im wesentlichen Teile der Anordnung gemäss Fig. 8 nochmals aufgezeichnet. Wie erläutert wurde, ist die erfindungsgemässe, durch die beiden Dipole 3 und 5 in y-Richtung bewirkte Bündelungssteuerung des Strahls je nach Auslegung der Dipole, insbesondere je nach ihrer Länge, in x-Richtung weitgehendst unabhängig von der Lage des Strahles in x-Richtung. Wird nun, wie beispielsweise aus der US-A- 4 064 352 oder der US-A- 3 420 977 bekannt, der Strahl einer starken Umlenkung unterworfen, und zwar in einem solchen Masse, dass bereits kurz nach Verlassen des Strahlerzeugers, entsprechend 15 in Fig. 9, Umlenkkräfte auf den Strahl ausgeübt werden müssen, um auf vernünftig kurzer Strecke den Strahl ins Ziel zu bringen, so wird vorgeschlagen, eine solche Umlenkung im wesentlichen in der zweiten Ebene vorzunehmen.

Dies ist in Fig. 9 dargestellt, worin die Umlenkeinrichtung, beispielsweise gemäss der US-A- 3 420 977, ein Umlenk-Flussdichtefeld $B_U$ erzeugt, welches gemäss Fig. 9 im wesentlichen in y-Richtung verläuft. Dadurch wird, wie gestrichelt dargestellt, der Strahl S zunehmend umgelenkt und kann eine Umlenkung bis in den Bereich von 270° oder mehr erfahren. Da eine solche Umlenkeinrichtung mit Erzeugung des Umlenkfeldes $B_U$ unmittelbar nach dem Strahlerzeuger 15 wirksam werden muss, um den Strahl auf möglichst kurzer Strecke, wie erfordert, umzulenken, muss bereits an der erfindungsgemäss vorgesehenen Bündelungssteuerung mit Verschiebungen des Strahls S in x-Richtung gerechnet werden, insbesondere auch wenn die Umlenkung moduliert wird, um den Strahl am Ziel zu verschieben.

Da die erfindungsgemäss bewirkte Steuerung der Bündelung in x-Richtung im wesentlichen unabhängig ist von der Lage des Strahles in dieser Richtung, wird mithin die Umlenkung vorzugsweise in der Ebene $E_2$ vorgenommen.

Anhand der Fig. 4 und 5 sowie 6 wurden vorgängig die Auswirkungen diskutiert, wenn zusätzlich zum erwähnten ersten Flussdichtefeld $\bar{B}_1$, $\bar{B}_2$, senkrecht dazu, ein zweites Flussdichtefeld $\bar{B}_3$, $\bar{B}_4$ angelegt wird.

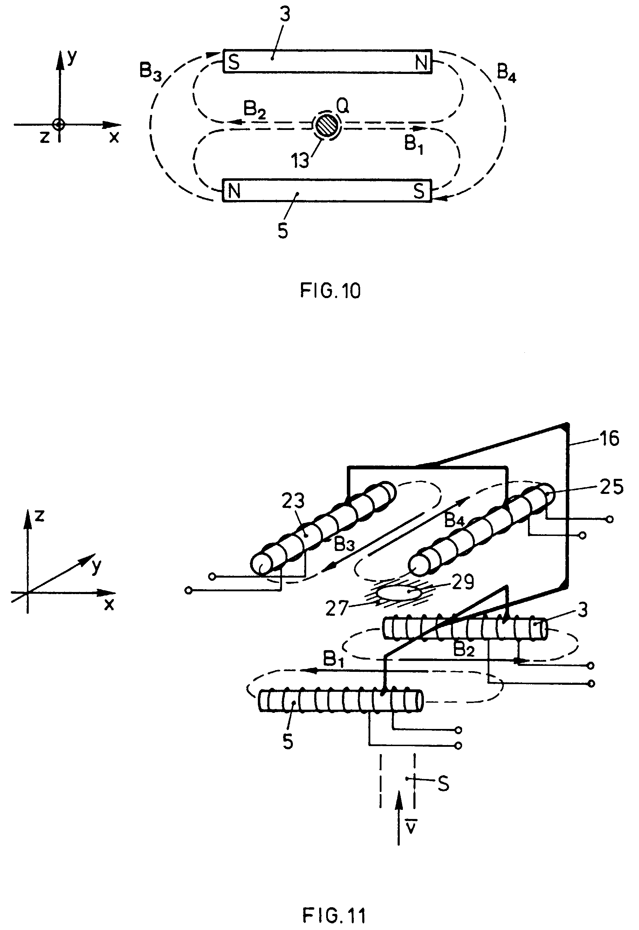

In Fig. 10 ist schematisch in Aufsicht die Anordnung der beiden Dipole 3 und 5 gemäss den Fig. 8 bzw. 9 dargestellt. Je nach Abstand der beiden Dipole 3 und 5 in y-Richtung betrachtet und ihrer Länge in x-Richtung betrachtet, entstehen auch auf dem vorgesehenen Durchtrittsbereich 13 für den Strahl S mit seiner Durchtrittsfläche Q wirksame Flussdichtefelder $\bar{B}_3$ und $\bar{B}_4$, wie schematisch in Fig. 4 dargestellt wurde. Damit wird durch entsprechende Dimensionierung der Anordnung mit den Dipolen 3 und 5 die Flussdichtefeldkonfiguration gemäss Fig. 4 mit der dort dargestellten Feldpolung direkt erreicht und mithin die anhand von Fig. 6 diskutierten Vorteile bezüglich Inversion von Zielflächen-Ausdehnungsänderungen bezüglich der Durchtrittsflächen-Ausdehnungsänderung von Q.

Grundsätzlich wird mithin angestrebt, wenn an der Anordnung eine Einrichtung zur Strahlerzeugung sowie der Art einer Elektronenoptik vorgesehen ist (je nach Strahlpartikelart), welche entlang der Strahlausbreitung mindestens einen Einschnürungs-Bereich des Strahls erzeugt, wie anhand von Fig. 6 erläutert wurde, die Magnetanordnung, wie beispielsweise anhand von Fig. 8, 9 oder 10 dargestellt, und die Einrichtung, bei welcher es sich beispielsweise um die in Fig. 9 dargestellte Umlenkungseinrichtung handeln kann, sowie um einen Strahlerzeuger bekannter Bauart so aufeinander abzustimmen, dass sich eine Durchtrittsflächenquerschnittsänderung im Bereich des Einflusses der durch die Magnetanordnung mit den Dipolen 3 und 5 bewirkten magnetischen Flussdichte $\bar{B}_1$ bis $\bar{B}_4$, invers auf eine Durchmesseränderung einer Strahlzielfläche mindestens in eine Richtung auswirkt, wie dies detailliert anhand von Fig. 6 erörtert wurde. Dies wird mit der Anordnung gemäss Fig. 10 bei einer Umlenkungseinrichtung und einem Strahlerzeuger, die einen Einschnürungs-Bereich gemäss Fig. 6b erzeugen, erreicht.

In Fig. 11 ist schematisch eine Magnetanordnung dargestellt, welche es erlaubt, die Flussdichte $\bar{B}_1$, $\bar{B}_2$ und die weitere Flussdichte $\bar{B}_3$, $\bar{B}_4$ senkrecht dazu unabhängig voneinander anzusteuern. Hierzu sind entlang der Ausbreitungsrichtung für den Strahl S einerseits die beiden Dipole 3, 5 vorgesehen und, diesbezüglich entlang der Strahlausbreitungsrichtung versetzt, senkrecht zu den Dipolen 3 und 5, weitere Dipole 23 und 25, welche das Flussdichte-feld $\bar{B}_3$, $\bar{B}_4$ gemäss Fig. 5 oder gemäss Fig. 4 ansteuern. Durch Vorsehen eines magnetischen Schirmes 27 mit einer Durchtrittsöffnung 29 für den Strahl werden die beiden unabhängig voneinander anzusteuernden Flussdichtefelder $\bar{B}_1$, $\bar{B}_2$ und $\bar{B}_3$, $\bar{B}_4$ voneinander weitgehend entkoppelt. Auf diese Art und Weise ist es möglich, den Strahl sowohl in Richtung x, wie auch in Richtung y, unabhängig voneinander in seiner Bündelung zu steuern. Wie schematisch bei 16 dargestellt, werden die beiden Dipolpaare 3, 5, 23 und 25 bezüglich des vorgesehenen Bereiches für den Strahl fixiert.

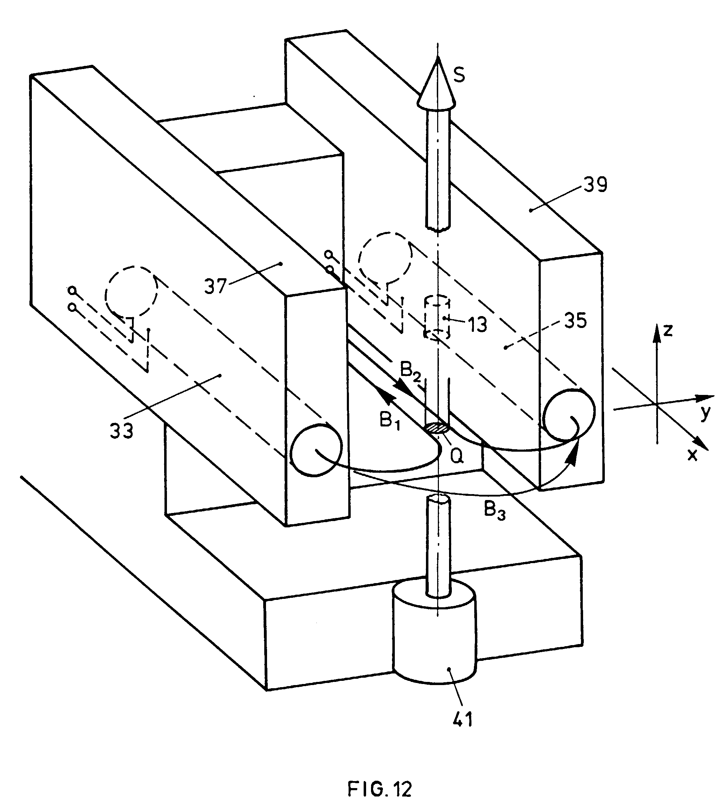

In Fig. 12 ist schematisch ein bevorzugter Aufbau der erfindungsgemässen Anordnung dargestellt. Zwei Elektromagnete 33 und 35, entsprechend den Dipolen 3 und 5 der Fig. 8, 9 oder 10, sind parallel zueinander in je einer backenartigen Halterung 37 bzw. 39 eingebettet. Die Halterungen 37 und 39 sind mindestens im Bereich der Elektromagnete 33, 35 aus nicht ferromagnetischem Material ausgebildet, sind aber, um auch effizient gekühlt werden zu können, bevorzugterweise aus Partien unterschiedlicher Metalle zusammengesetzt, insbesondere aus Partien aus Kupfer und einem rostfreien Stahl.

In schematisch dargestellter Art und Weise ist eine Fixieranordnung für einen Strahlerzeuger 41 vorgesehen, der den Strahl S, insbesondere den Elektronenstrahl, mittig zwischen den Halterungen 37 und 39 abgibt. Der Feldverlauf mit dem Flussdichtefeld $\bar{B}_1$, $\bar{B}_2$ ist in Fig. 12 beispielsweise eingetragen, ebenso die Wirkung des Querfeldes $\bar{B}_3$.

Mit der erfindungsgemässen Anordnung bzw. den erfindungsgemässen Verfahren wurde ein Stellbereich der Flächenausdehnung des Strahls auf einem Ziel von 1:10 erreicht, z.B. von 5mm bis 50mm Brennfleckdurchmesser, sogar bei einer Strahlumlenkung von ca. 270°. Dies konnte dynamisch bei Stellfrequenzen bis 1kHz erreicht werden. Damit ist es ohne weiteres auch möglich, gegebenenfalls die Bündelung des Strahls zu pulsen.

**Patentansprüche**

1. Verfahren zur Steuerung der Bündelung eines Strahls (S) monopolar geladener Teilchen, insbesondere Elektronen, der durch eine zur Strahlachse (Z) senkrechte erste Ebene ($E_1$) mit einer Strahldurchtrittsfläche (Q) hindurchtritt, wobei beiderseits einer die Strahlachse (Z) enthaltenden zweiten Ebene ($E_2$) zwei magnetische Flussdichte-Felder ($B_1$, $B_2$) derart angelegt werden, dass die Feldlinien mit ihrer Hauptvektorkomponente im Bereich der zweiten Ebene ($E_2$) im wesentlichen parallel zur ersten und zweiten Ebene verlaufen und die beiden Felder einander entgegengerichtete Polarität haben, und wobei durch Steuern der beiden Felder die Ausdehnung der Strahldurchtrittsfläche (Q) in der zur zweiten Ebene ($E_2$) senkrechten Richtung (Y) verändert wird, dadurch gekennzeichnet, dass die beiden magnetischen Flussdichte-Felder ($B_1$, $B_2$) über eine Strecke, die wesentlich grösser als die Ausdehnung der Strahldurchtrittsfläche (Q) parallel zur zweiten Ebene ($E_2$) ist, mit im wesentlichen zueinander parallelen Feldlinien erzeugt werden, derart dass die Ausdehnung der Strahldurchtnittsfläche (Q) in der senkrechten Richtung (y) in Grenzen unabhängig von der Lage der Durchtrittsfläche (Q) in der Richtung (x) quer zu der zur zweiten Ebene ($E_2$) senkrechten Richtung (y) ist.

2. Verfahren nach Anspruch 1, dadurch gekennzeichnet, dass man die zwei Flussdichte-Felder ($B_1$, $B_2$) bezüglich der zweiten Ebene ($E_2$) mit im wesentlichen symmetrischem Betrags-Verlauf anlegt und diese Symmetrie bei gesteuerter Veränderung der Felder ($B_1$, $B_2$) im wesentlichen beibehält.

3. Verfahren nach einem der Ansprüche 1 oder 2, dadurch gekennzeichnet, dass die Felder ($B_1$, $B_2$) beidseits der zweiten Ebene ($E_2$) über einen Bereich, der wesentlich länger ist als die Ausdehnung der Durchtrittsfläche (Q) parallel zur zweiten Ebene ($E_2$) im wesentlichen konstant ausgelegt werden.

4. Verfahren nach einem der Ansprüche 1 bis 3, dadurch gekennzeichnet, dass man bezüglich einer dritten Ebene ($E_3$), senkrecht zur ersten ($E_1$) und zur zweiten ($E_2$) beidseits zwei weitere Flussdichte-Felder ($B_3$, $B_4$) anlegt, mit im Bereich der dritten Ebene ($E_3$) beidseits im wesentlichen parallelen Vektorkomponenten umgekehrter Polarität, vorzugsweise bezüglich der dritten Ebene ($E_3$) im wesentlichen symmetrischer Beträge.

5. Verfahren nach Anspruch 4, dadurch gekennzeichnet, dass man den Feldverlauf der weiteren Flussdichte-Felder, im Bereich der Strahldurchtrittsfläche (Q), beidseits der dritten Ebene, über mindestens eine der Durchtrittsflächenausdehnung entsprechende Länge im wesentlichen parallel auslegt.

6. Verfahren nach Anspruch 4, dadurch gekennzeichnet, dass die Felder beidseits der dritten Ebene über einen Bereich, der wesentlich länger ist als die Ausdehnung der Durchtrittsfläche im wesentlichen konstant ausgelegt werden.

7. Verfahren nach einem der Ansprüche 4 bis 6, dadurch gekennzeichnet, dass man die weiteren Felder ($B_3$, $B_4$) so anlegt, dass, um die Durchtrittsfläche (Q) durch die erste Ebene ($E_1$) umlaufend, sich die Polaritäten der Feldvektoren ($B_1$, $B_2$, $B_3$, $B_4$) abwechseln.

8. Verfahren nach einem der Ansprüche 4 bis 7, dadurch gekennzeichnet, dass man die weiteren magnetischen Flussdichte-Felder ($B_3$, $B_4$) im wesentlichen ebenfalls in der ersten Ebene ($E_1$) anlegt.

9. Verfahren nach einem der Ansprüche 4 bis 8, dadurch gekennzeichnet, dass man die zwei ($B_1$, $B_2$) und die zwei weiteren ($B_3$, $B_4$) magnetischen Flussdichte-Felder in Strahlausbreitungsrichtung (Z), versetzt anlegt sie voneinander entkoppelt, vorzugsweise voneinander abschirmt.

10. Verfahren nach einem der Ansprüche 1 bis 9, wobei man den Strahl (S) zusätzlich umlenkt, derart, dass, gesteuert, seine Durchtrittsfläche (Q) durch die erste Ebene ($E_1$) verschieblich ist, dadurch gekennzeichnet, dass man die gesteuerte Umlenkung ($B_U$) in der zweiten Ebene ($E_2$) vornimmt, derart, dass sich die Strahldurchtrittsfläche (Q), im wesentlichen parallel zu den Vektoren der zwei magnetischen Flussdichte-Felder ($B_1$, $B_2$) verschiebt.

11. Verfahren nach Anspruch 10, dadurch gekennzeichnet, dass man den Strahl um mehr als 90°, insbesondere um mehr als 180° umlenkt.

12. Verfahren nach einem der Ansprüche 1 bis 11, dadurch gekennzeichnet, dass man die Wirkung der FlussdichteFelder ($B_1$, $B_2$, $B_3$, $B_4$) auf eine Strahlzielfläche (M) bezüglich der Wirkung auf die Durchtrittsfläche (Q) durch räumliches Festlegen mindestens eines Einschnürungs-Bereiches (K) des Strahls festlegt, wie z.B. invertiert.

13. Verfahren nach einem der Ansprüche bis 12, dadurch gekennzeichnet, dass man die Ausdehnung der Strahldurchtrittsfläche (Q) in der zur zweiten Ebene ($E_2$) senkrechten Richtung (Y) dynamisch verandert, wie moduliert, vorzugsweise mit einer Stellfrequenz bis 1kHz.

14. Verfahren nach Anspruch 13, dadurch gekennzeichnet, dass man die Ausdehnung Strahldurchtrittsfläche (Q) in der zur zweiten Ebene ($E_2$) senkrechten Richtung (Y) pulst.

15. Anordnung zur Steuerung der Bündelung eines Strahls monopolar geladener Partikel, insbesondere von Elektronen, mit einem Bereich (13) für den Strahldurchtritt, wobei eine gesteuerte Magnetanordnung vorgesehen ist, mittels welcher die Ausdehnung der Strahldurchtrittsfläche (Q) durch eine quer zum Strahlbereich liegende erste Ebene ($E_1$) in mindestens einer ersten Richtung (Y) gesteuert verändert wird, indem mit der Magnetanordnung zwei magnetische Flussdichte-Felder ($B_1$, $B_2$) in die erste Ebene ($E_1$) gelegt werden mit Vektorkomponenten, welche, beidseits und im Bereich einer zweiten Ebene ($E_2$) senkrecht zur ersten Richtung (Y) und zur ersten Ebene ($E_1$), zueinander im wesentliche parallel sind, und einander entgegengesetzte Polaritäten haben, dadurch gekennzeichnet, dass die Magnetanordnung (3, 5, 23, 25, 33, 35) so ausgebildet ist, dass die Flussdichte-Felder ($B_1$, $B_2$) mit zueinander im Bereich der zweiten Ebene ($E_2$) im wesentlichen parallelen Feldlinien erzeugt werden, über eine Strecke, die wesentlich grösser ist, als die Ausdehnung der Strahldurchtrittsfläche (Q) parallel zur zweiten Ebene ($E_2$), derart, dass die Ausdehnung der Strahldurchtrittsfläche (Q) in der ersten Richtung (y) in Grenzen unabhängig von der Lage der Durchtrittsfläche (Q) in der zweiten Richtung (x) quer zu der ersten Richtung (y).

16. Anordnung nach Anspruch 15, dadurch gekennzeichnet, dass die Magnetanordnung durch zwei im wesentlichen parallele Stabmagnete gebildet ist.

17. Anordnung nach einem der Ansprüche 15 oder 16, dadurch gekennzeichnet, dass eine Steuerung (11) für die Magnetanordnung vorgesehen ist, mittels welcher diese so angesteuert wird, dass das Flussdichte-Feld beidseits der zweiten Ebene ($E_2$) einen diesbezüglich symmetrischen Verlauf seiner Beträge aufweist.

18. Anordnung nach einem der Ansprüche 15 bis 17, dadurch gekennzeichnet, dass die Magnetanordnung (3, 5, 23, 25, 33, 35) so ausgebildet ist, dass der Verlauf des Flussdichte-Feldes ($B_1$, $B_2$) beidseits der zweiten Ebene ($E_2$) über einen Bereich, der wesentlich länger ist als die Ausdehnung der Durchtrittsfläche (Q), im wesentlichen konstant ist.

19. Anordnung nach einem der Ansprüche 15 bis 18, dadurch gekennzeichnet, dass die Magnetanordnung zwei im wesentlichen parallel zur zweiten Ebene ($E_2$) angeordnete magnetische Dipole (3, 5, 23, 25, 33, 35) aufweist.

20. Anordnung nach Anspruch 19, dadurch gekennzeichnet, dass die beiden magnetischen Dipole (3, 5, 23, 25, 33, 35) im wesentlichen in der ersten Ebene ($E_1$) liegen.

**21.** Anordnung nach Anspruch 20, dadurch gekennzeichnet, dass die in der ersten Ebene ($E_1$) liegenden magnetischen Dipole (3, 5, 33, 35), bezüglich der zweiten Ebene ($E_2$) im wesentlichen symmetrisch angeordnet sind.

**22.** Anordnung nach einem der Ansprüche 15 bis 21, mit einer gesteuerten Umlenkreinrichtung ($B_U$) für den Strahl (S), dadurch gekennzeichnet, dass die Umlenkeinrichtung eine Strahlumlenkung im wesentlichen in der zweiten Ebene ($E_2$) vornimmt, vorzugsweise um mehr als 90°, dabei vorzugsweise um mehr als 180°.

**23.** Anordnung nach einem der Ansprüche 15 bis 22, dadurch gekennzeichnet, dass die Magnetanordnung weitere Flussdichte-Felder ($B_3$, $B_4$) senkrecht zur zweiten Ebene ($E_2$) erzeugt, mit beidseits des Bereiches (13) für den Strahl (S) umgekehrter Polarität.

**24.** Anordnung nach einem der Ansprüche 22 oder 23, mit einer Einrichtung zur Strahlerzeugung der Art einer Elektronenoptik,welche entlang der Strahlausbreitung mindestens einen Einschnürungs-Bereich (K) des Strahls (S) erzeugt, dadurch gekennzeichnet, dass die Magnetanordnung (3, 5, 23, 25, 33, 35) und die Einrichtung ($B_U$) so aufeinander abgestimmt sind, dass sich die Durchtrittsflächen-Querschnittsänderung im Bereich des Einflusses der durch die Magnetanordnung bewirkten magnetischen Flussdichte ($B_1$, $B_2$, $B_3$ $B_4$) invers auf eine Durchmesseränderung einer Strahlzielfläche mindestens in einer der ersten oder zweiten Richtung (X) auswirkt.

**25.** Anordnung nach einem der Ansprüche 15 bis 24, dadurch gekennzeichnet, dass die Magnetanordnung zwei magnetische Dipole (3, 5, 33, 35) aufweist, welche je in einer von zwei auf Abstand gehaltenen Halterungen (37, 39) angeordnet sind, und dass der Bereich für den Strahl zwischen den Halterungen (37, 39) durchläuft.

**26.** Anordnung nach einem der Ansprüche 15 bis 25, dadurch gekennzeichnet, dass eine Positionier- und Fixieranordnung für einen Strahlerzeuger (15, 41) vorgesehen ist, derart, dass der erzeugte Strahl (S) durch den vorgegebenen Bereich (13) läuft.

**27.** Anordnung nach Anspruch 25, dadurch gekennzeichnet, dass die Halterungen (37, 39) im Bereich der Dipole (33, 35) aus einem weitgehend nicht ferromagnetischen Material bestehen und die Dipole vorzugsweise in den Halterungen (37, 39) vakuumdicht gekapselt sind.

**28.** Anordnung nach Anspruch 25, dadurch gekennzeichnet, dass die Halterungen aus Partien unterschiedlicher Metalle, wie aus Kupfer und/oder einem rostfreien Stahl, bestehen.

**29.** Anordnung nach einem der Ansprüche 15 bis 28, dadurch gekennzeichnet, dass die Magnetanordnung Permanent- und/oder Elektromagnete umfasst.

**30.** Elektronenstrahlerzeuger mit einer Anordnung nach einem der Ansprüche 15 bis 29.

**31.** Vakuumbehandlungsanlage mit einem Elektronenstrahlerzeuger nach Anspruch 30.

**Claims**

**1.** A process for controlling the focusing of a unipolar charged particle beam, in particular an electron beam (S), traversing with a beam passing area (Q) a first plane ($E_1$) perpendicular to the beam axis (Z), wherein two magnetic flux-density fields ($E_1$, $B_2$) are so applied on both sides of a second plane ($E_2$) containing the beam axis (Z), that the field lines extend with their major vector component within the second plane ($E_2$), generally parallel to the first and second planes, and that both fields have opposite polarities, and wherein the extent of the beam passing area (Q) in the direction (Y) perpendicular to the second plane ($E_2$) is changed by controlling the two fields, characterized in that the two magnetic flux-density fields ($B_1$, $B_2$) are generated with generally mutually parallel field lines over a distance, which is substantially larger than the extent of the beam passing area (Q), parallel to the second plane ($E_2$), such that the extent of the beam passing area (Q) in the perpendicular direction (Y) is independent, to a certain degree, of the position of said passing area (Q) in the direction (X) transverse to the direction (Y) perpendicular to the second plane ($E_2$).

**2.** The process according to claim 1, characterized in that the two flux-density fields ($B_1$, $B_2$) are applied according to a curve of values generally symmetrical with respect to the second plane ($E_2$), and in that said symmetry is generally maintained when the fields ($B_1$, $B_2$) are controllably changed.

**3.** The process according to claim 1 or 2, characterized in that the fields ($B_1$, $B_2$) applied on both sides of the second plane ($E_2$) are designed to be generally constant over a region, the length of which is substantially larger than the extent of the passing area (Q), parallel to the second plane ($E_2$).

**4.** The process according to claim 1 to 3, characterized in that, on both sides of a third plane ($E_3$) per-

pendicular to the first and second planes ($E_1$, $E_2$), there are applied two additional flux-density fields ($B_3$, $B_4$) having in the region of the third plane ($E_3$), on both sides, generally parallel vector components of opposite polarities, and preferably values which are generally symmetrical with respect to the third plane ($E_3$).

5. The process according to claim 4, characterized in that the curve of the additional flux-density fields is so designed as to be generally parallel in the region of the beam passing area (Q), on both sides of the third plane, at least over a length corresponding to the extent of the passing area.

6. The process according to claim 4, characterized in that the fields applied on both sides of the third plane are so designed as to be generally constant over a region, the length of which is substantially larger than the extent of the passing area.

7. The process according to any of claims 4 to 6, characterized in that the additional fields ($B_3$, $B_4$) are so applied that the polarities of the field vectors ($B_1$, $B_2$, $B_3$, $B_4$) are disposed alternately around the passing area (Q) through the first plane ($E_1$).

8. The process according to any of claims 4 to 7, characterized in that the additional magnetic flux-density fields ($B_3$, $B_4$) are also applied generally in the first plane ($E_1$).

9. The process according to any of claims 4 to 8, characterized in that the two magnetic flux-density fields ($B_1$, $B_2$) and the two additional fields ($B_3$, $B_4$) are applied while being offset in the direction of propagation (Z) of the beam, and are uncoupled, preferably by means of a screen.

10. The process according to any of claims 1 to 9, wherein the beam (S) is further deflected so that its passing area (Q) through the first plane ($E_1$) is controllably movable, characterized in that the controlled deflection ($B_U$) is performed in the second plane ($E_2$) so that said beam passing area (Q) moves generally parallel to the vectors of the two magnetic flux-density fields ($B_1$, $B_2$).

11. The process according to claim 10, characterized in that the beam is deflected by more than 90°, in particular by more than 180°.

12. The process according to any of claims 1 to 11, characterized in that the action of the flux-density fields ($B_1$, $B_2$, $B_3$, $B_4$) on a beam target area (M) is determined, e.g. inverted, with respect to the action on the passing area (Q) by space determinating at least one beam narrowing zone (K).

13. The process according to any of claims 1 to 12, characterized in that the extent of the beam passing area (Q) in the direction (Y) perpendicular to the second plane ($E_2$) is dynamically changed, e.g. modulated, preferably with a set frequency up to 1 kHz.

14. The process according to claim 13, characterized in that the extent of the beam passing area (Q) in the direction (Y) perpendicular to the second plane ($E_2$) is pulsed.

15. An installation for controlling the focusing of a unipolar charged particle beam, in particular an electron beam, comprising a region (13) provided for the passage of the beam, wherein there is provided a controlled magnetic device, whereby the extent of the beam passing area (Q) through a first plane ($E_1$) transverse to the beam region is controllably changed in at least one first direction (Y), and wherein two magnetic flux-density fields ($B_1$, $B_2$) are applied by the magnetic device in the first plane ($E_1$) with vector components, which, on both sides and in the region of a second plane ($E_2$) perpendicular to the first direction (Y) and first plane ($E_1$), are generally mutually parallel and have opposite polarities, characterized in that the magnetic device (3, 5, 23, 25, 33, 35) is so designed that the flux-density fields ($B_1$, $B_2$) are generated with generally mutually parallel field lines in the region of the second plane ($E_2$), over a distance, which is substantially larger than the extent of the beam passing area (Q), parallel to the second plane ($E_2$), such that the extent of the beam passing area (Q) in the first direction (Y) is independent, to a certain degree, of the position of said passing area (Q) in the second direction (X) transverse to the first direction (Y).

16. The installation according to claim 15, characterized in that the magnetic device is formed by two generally parallel straight magnets.

17. The installation according to claim 15 or 16, characterized in that a control (11) is provided for the magnetic device, whereby the latter is so controlled that the flux-density field applied on both sides of the second plane ($E_2$) exhibits a curve of values which is symmetrical to said second plane.

18. The installation according to any of claims 15 to 17, characterized in that the magnetic device (3, 5, 23, 25, 33, 35) is so designed that the curve of the flux-density field ($B_1$, $B_2$) applied on both sides of the second plane ($E_2$) is generally constant over a region, the length of which is substantially larger than the extent of the passing area (Q).

19. The installation according to any of claims 15 to 18, characterized in that the magnetic device comprises two magnetic dipoles (3, 5, 23, 25, 33, 35) disposed generally parallel to the second plane (E$_2$).

20. The installation according to claim 19, characterized in that the two magnetic dipoles (3, 5, 23, 25, 33, 35) are generally located in the first plane (E$_1$).

21. The installation according to claim 20, characterized in that the magnetic dipoles (3, 5, 33, 35) located in the first plane (E$_1$) are disposed generally symmetrically with respect to the second plane (E$_2$).

22. The installation according to any of claims 15 to 21, comprising a controlled deflecting device (B$_U$) for the beam (S), characterized in that the deflecting device performs a deflection of the beam generally in the second plane (E$_2$), preferably by more than 90°, and particularly by more than 180°.

23. The installation according to any of claims 15 to 22, characterized in that the magnetic device generates additional flux-density fields (B$_3$, B$_4$) perpendicular to the second plane (E$_2$) and having an opposite polarity on both sides of the region (13) provided for the beam (S).

24. The installation according to claim 22 or 23, comprising a beam generating device, such as an electro-optical system, generating at least one narrowing zone (K) of the beam (S) along the propagation thereof, characterized in that the magnetic device (3, 5, 23, 25, 33, 35) and the device (B$_u$) are so matched that the change in cross-section of the passing area in the influence region of the magnetic flux-density fields (B$_1$, B$_2$, B$_3$, B$_4$) induced by the magnetic device has a reverse effect on a change in diameter of a beam target area, at least in one of the first and second (X) directions.

25. The installation according to any of claims 15 to 24, characterized in that the magnetic device comprises two magnetic dipoles (3, 5, 33, 35) disposed in two respective spaced apart mountings (37, 39), and in that the region provided for the beam extends between said mountings (37, 39).

26. The installation according to any of claims 15 to 25, characterized in that a positioning and securing device is provided for a beam generator (15, 41), so that the generated beam (S) traverses the predefined region (13).

27. The installation according to claim 25, characterized in that, in the region of the dipoles (33, 35), the mountings (37, 39) consist of a substantially non-ferromagnetic material, and the dipoles are preferably vacuum tightly encapsulated in said mountings (37, 39).

28. The installation according to claim 25, characterized in that the mountings consist of parts made of differing metals, e.g. of copper and/or stainless steel.

29. The installation according to any of claims 15 to 28, characterized in that the magnetic device comprises permanent magnets and/or electro-magnets.

30. An electron gun with an installation according to any of claims 15 to 29.

31. A vacuum processing installation with an electron gun according to claim 30.

## Revendications

1. Procédé pour commander la focalisation d'un faisceau (S) de particules à charge unipolaire, en particulier d'électrons, qui traverse avec une surface de passage de faisceau (Q) un premier plan (E$_1$) perpendiculaire à l'axe (Z) du faisceau, selon lequel deux champs magnétiques à densité de flux (B$_1$, B$_2$) sont appliqués, des deux côtés d'un deuxième plan (E$_2$) contenant l'axe (Z) du faisceau, de telle sorte que les lignes de champ soient globalement parallèles, avec leur composante vectorielle principale dans le deuxième plan (E$_2$), au premier et au deuxième plan et que les deux champs aient des polarités opposées, et selon lequel l'étendue de la surface de passage de faisceau (Q) dans le sens (Y) perpendiculaire au deuxième plan (E$_2$) est modifiée grâce à une commande des deux champs, caractérisé en ce que les deux champs magnétiques à densité de flux (B$_1$, B$_2$) sont générés avec des lignes de champs globalement parallèles entre elles, sur une distance nettement supérieure à l'étendue de la surface de passage de faisceau (Q) parallèlement au deuxième plan (E$_2$), de telle sorte que l'étendue de la surface de passage de faisceau (Q) dans le sens perpendiculaire (Y) est indépendante, dans certaines limites, de la position de la surface de passage (Q) dans le sens (X) transversal par rapport au sens (Y) perpendiculaire au deuxième plan (E$_2$).

2. Procédé selon la revendication 1, caractérisé en ce qu'on applique les deux champs à densité de flux (B$_1$, B$_2$) suivant une courbe de valeurs globalement symétrique par rapport au deuxième plan (E$_2$), et on maintient globalement cette symétrie dans le cas d'une modification commandée des champs (B$_1$, B$_2$).

3. Procédé selon la revendication 1 ou 2, caractérisé en ce que les champs ($B_1$, $B_2$) appliqués des deux côtés du deuxième plan ($E_2$) sont étudiés pour être globalement constants sur une zone dont la longueur est nettement supérieure à l'étendue de la surface de passage (Q) parallèlement au deuxième plan ($E_2$).

4. Procédé selon l'une des revendications 1 à 3, caractérisé en ce qu'on applique, des deux côtés d'un troisième plan ($E_3$) perpendiculaire au premier ($E_1$) et au deuxième ($E_2$), deux champs à densité de flux supplémentaires ($B_3$, $B_4$) présentant dans la zone du troisième plan ($E_3$), des deux côtés, des composantes vectorielles globalement parallèles de polarité opposée, et de préférence des valeurs globalement symétriques par rapport au troisième plan ($E_3$).

5. Procédé selon la revendication 4, caractérisé en ce qu'on étudie la courbe des champs à densité de flux supplémentaires pour qu'elle soit globalement parallèle dans la zone de la surface de passage de faisceau (Q), des deux côtés du troisième plan, au moins sur une longueur correspondant à l'étendue de la surface de passage.

6. Procédé selon la revendication 4, caractérisé en ce que les champs appliqués des deux côtés du troisième plan sont étudiés pour être globalement constants sur une zone dont la longueur est nettement supérieure à l'étendue de la surface de passage.

7. Procédé selon l'une des revendications 4 à 6, caractérisé en ce qu'on applique les champs supplémentaires ($B_3$, $B_4$) de telle sorte que les polarités des vecteurs de champs ($B_1$, $B_2$, $B_3$, $B_4$) alternent autour de la surface (Q) de passage à travers le premier plan ($E_1$).

8. Procédé selon l'une des revendications 4 à 7, caractérisé en ce qu'on applique les champs magnétiques à densité de flux supplémentaires ($B_3$, $B_4$) globalement dans le premier plan ($E_1$), également.

9. Procédé selon l'une des revendications 4 à 8, caractérisé en ce qu'on applique les deux champs magnétiques à densité de flux ($B_1$, $B_2$) et les deux champs supplémentaires ($B_3$, $B_4$) en les décalant dans le sens de propagation (Z) du faisceau et on les découple, de préférence à l'aide d'un écran.

10. Procédé selon l'une des revendications 1 à 9, selon lequel on dévie en outre le faisceau (S) de sorte que sa surface (Q) de passage à travers le premier plan ($E_1$) est mobile de façon commandée, caractérisé en ce qu'on procède à la déviation commandée ($B_U$) dans le deuxième plan ($E_2$) de telle sorte que la surface de passage de faisceau (Q) se déplace globalement parallèlement aux vecteurs des deux champs magnétiques à densité de flux ($B_1$, $B_2$).

11. Procédé selon la revendication 10, caractérisé en ce qu'on dévie le faisceau de plus de 90°, notamment de plus de 180°.

12. Procédé selon l'une des revendications 1 à 11, caractérisé en ce qu'on détermine, par exemple on inverse l'action des champs à densité de flux ($B_1$, $B_2$, $B_3$, $B_4$) sur une surface cible de faisceau (M) par rapport à l'action sur la surface de passage (Q) en déterminant dans l'espace au moins une zone de rétrécissement (K) du faisceau.

13. Procédé selon l'une des revendications 1 à 12, caractérisé en ce qu'on modifie par voie dynamique, par exemple par modulation, l'étendue de la surface de passage de faisceau (Q) dans le sens (Y) perpendiculaire au deuxième plan ($E_2$), de préférence avec une fréquence de réglage allant jusqu'à 1 kHz.

14. Procédé selon la revendication 13, caractérisé en ce qu'on pulse l'étendue de la surface de passage de faisceau (Q) dans le sens (Y) perpendiculaire au deuxième plan ($E_2$).

15. Installation pour commander la focalisation d'un faisceau de particules à charge unipolaire, en particulier d'électrons, comportant une zone (13) pour le passage du faisceau, dans laquelle on prévoit un dispositif magnétique commandé à l'aide duquel l'étendue de la surface (Q) de passage du faisceau à travers un premier plan ($E_1$) transversal par rapport à la zone du faisceau est modifiée de façon commandée dans au moins un premier sens (Y), deux champs magnétiques à densité de flux ($B_1$, $B_2$) étant appliqués à l'aide du dispositif magnétique dans le premier plan ($E_1$) avec des composantes vectorielles qui, des deux côtés et dans la zone d'un deuxième plan ($E_2$) perpendiculaire au premier sens (Y) et au premier plan ($E_1$), sont globalement parallèles entre elles et ont des polarités opposées, caractérisée en ce que le dispositif magnétique (3, 5, 23, 25, 33, 35) est conçu pour que les champs à densité de flux ($B_1$, $B_2$) soient générés avec des lignes de champs globalement parallèles entre elles dans la zone du deuxième plan ($E_2$), sur une distance nettement supérieure à l'étendue de la surface de passage de faisceau (Q) parallèlement au deuxième plan ($E_2$), de telle sorte que l'étendue de la surface de passage de faisceau (Q) dans le premier sens (Y) soit indépendante, dans certaines limites, de la position de la surface de passage (Q) dans le second sens (X) transversal par rapport au premier (Y).

**16.** Installation selon la revendication 15, caractérisée en ce que le dispositif magnétique est formé par deux aimants droits globalement parallèles.

**17.** Installation selon la revendication 15 ou 16, caractérisée en ce qu'il est prévu une commande (11) pour le dispositif magnétique, à l'aide de laquelle celui-ci est commandé pour que le champ à densité de flux appliqué des deux côtés du deuxième plan $(E_2)$ présente une courbe de valeurs symétrique par rapport à ce plan.

**18.** Installation selon l'une des revendications 15 à 17, caractérisée en ce que le dispositif magnétique (3, 5, 23, 25, 33, 35) est conçu pour que la courbe du champ à densité de flux $(B_1, B_2)$ appliqué des deux côtés du deuxième plan $(E_2)$ soit globalement constante sur une zone dont la longueur est nettement supérieure à l'étendue de la surface de passage (Q).

**19.** Installation selon l'une des revendications 15 à 18, caractérisée en ce que le dispositif magnétique comporte deux dipôles magnétiques (3, 5, 23, 25, 33, 35) disposés globalement parallèlement au deuxième plan $(E_2)$.

**20.** Installation selon la revendication 19, caractérisée en ce que les deux dipôles magnétiques (3, 5, 23, 25, 33, 35) sont situés globalement dans le premier plan $(E_1)$.

**21.** Installation selon la revendication 20, caractérisée en ce que les dipôles magnétiques (3, 5, 33, 35) situés dans le premier plan $(E_1)$ sont disposés globalement symétriquement par rapport au deuxième plan $(E_2)$.

**22.** Installation selon l'une des revendications 15 à 21, comportant un dispositif de déviation commandé $(B_U)$ pour le faisceau (S), caractérisée en ce que le dispositif de déviation réalise une déviation de faisceau globalement dans le deuxième plan $(E_2)$, de préférence de plus de 90° et spécialement de plus de 180°.

**23.** Installation selon l'une des revendications 15 à 22, caractérisée en ce que le dispositif magnétique génère des champs à densité de flux supplémentaires $(B_3, B_4)$ perpendiculaires au deuxième plan $(E_2)$ et présentant une polarité inversée des deux côtés de la zone (13) prévue pour le faisceau (S).

**24.** Installation selon la revendication 22 ou 23, comportant un dispositif pour générer le faisceau tel qu'un système électro-optique, qui génère au moins une zone de rétrécissement (K) du faisceau (S) le long de la propagation de celui-ci, caractérisée en ce que le dispositif magnétique (3, 5, 23, 25, 33, 35) et le dispositif $(B_U)$ sont accordés pour que la variation de la section transversale de la surface de passage dans la zone d'influence des champs magnétiques à densité de flux $(B_1, B_2, B_3, B_4)$ provoqués par le dispositif magnétique ait un effet inverse sur une variation du diamètre d'une surface cible de faisceau, dans l'un au moins des premier et second (X) sens.

**25.** Installation selon l'une des revendications 15 à 24, caractérisée en ce que le dispositif magnétique comporte deux dipôles magnétiques (3, 5, 33, 35) qui sont disposés dans deux fixations respectives (37, 39) espacées l'une de l'autre, et en ce que la zone prévue pour le faisceau passe entre les fixations (37, 39).

**26.** Installation selon l'une des revendications 15 à 25, caractérisée en ce qu'un dispositif de positionnement et de fixation est prévu pour un générateur de faisceau (15, 41) de telle sorte que le faisceau généré (S) traverse la zone (13) prédéfinie.

**27.** Installation selon la revendication 25, caractérisée en ce que dans la zone des dipôles (33, 35), les fixations (37, 39) se composent d'un matériau largement non ferromagnétique et les dipôles sont de préférence enfermés de façon étanche au vide dans les fixations (37, 39).

**28.** Installation selon la revendication 25, caractérisée en ce que les fixations se composent de parties en métaux différents, par exemple en cuivre et/ou en acier inoxydable.

**29.** Installation selon l'une des revendications 15 à 28, caractérisée en ce que le dispositif magnétique comprend des aimants permanents et/ou des électro-aimants.

**30.** Canon électronique pourvu d'une installation selon l'une des revendications 15 à 29.

**31.** Installation de traitement sous vide pourvue d'un canon électronique selon la revendication 30.

FIG.1

FIG. 2

FIG.3

FIG.4

FIG.5

FIG.6a

FIG.6b

FIG.7

FIG.8

FIG.9

18

FIG.10

FIG.11

FIG. 12